# EUROPEAN PATENT SPECIFICATION

(11) **EP 1 152 647 B1**
(45) Date of publication and mention of the grant of the patent: **05.03.2008**
(21) Application number: 00109595.9
(22) Date of filing: 05.05.2000
(51) Int. Cl.: H05K 1/18, H05K 1/11, H05K 3/30

(54) **Power supply with no potential ignition source**
Stromversorgung ohne potentielle Zündquelle
Alimentation de courant sans source d'allumage potentielle

(43) Date of publication of application: 07.11.2001
(73) Proprietor: THOMSON multimedia, 92648 Boulogne Cédex (FR)
(72) Inventor: Lim, Yoon Choy, Putra, 81000 Kulai (MY)
(74) Representative: Arnold, Klaus-Peter

(56) References cited:
- DE-A- 3 916 944
- DE-U- 7 439 095
- US-A- 4 040 121
- PATENT ABSTRACTS OF JAPAN vol. 1995, no. 05, 30 June 1995 (1995-06-30) & JP 07 038223 A (FUJI ELECTRIC CO), 7 February 1995 (1995-02-07)
- PATENT ABSTRACTS OF JAPAN vol. 1997, no. 06, 30 June 1997 (1997-06-30) & JP 09 036517 A (TANITA KK), 7 February 1997 (1997-02-07)

## Description

The present invention relates to arranging components of an electric circuit within an apparatus while taking into consideration safety requirements especially due to IEC 60065.

According to IEC 60065 Sixth edition amendment 1 - Clause 2.8.11 'Potential Ignition Source', a Potential Ignition Source, in the following abbreviated as PIS, is caused by possible fault such as a faulty contact or interruption in an electrical connection, including a conductive pattern on a printed circuit board, which can start a fire if under normal operating conditions the open circuit voltage exceeds 50V(peak) a.c. or d.c. and the product of this open circuit voltage and the measured current through this possible fault exceeds 15VA.

Therefore, according to IEC 60065 Sixth edition amendment 1 - Clause 20 'Resistance To Fire', an apparatus shall be so designed that the start and spread of fire is prevented as far as possible, and shall not give rise to danger of fire to the surroundings of the apparatus. This is achieved as follows by using good engineering practice in design and production of the apparatus to avoid PIS, by using materials of low flammability for internal parts in the vicinity of a PIS and by using so-called FIRE ENCLOSURES to limit the spread of fire. The requirements are considered to be fulfilled, if the apparatus complies with the requirements 20.1 and 20.2.

However, according to IEC 60065 Sixth edition amendment 1 - Sub Clause 20.1.4 'Components and parts not covered by 20.1.1, 20.1.2 and 20.1.3 except FIRE ENCLOSURES', when the distance between a PIS and components or parts mentioned before does not exceed the values specified in Table 13 of IEC 60065, then these components and parts shall comply with the relevant flammability category according to IEC 60707 as specified in said Table 13, unless shielded from PIS by a barrier made of metal to meet the flammability category FV 0 according to IEC 60707. The barrier shall have dimensions covering at least the areas specified in said Table 13.

Such a barrier shall have a distance to a PIS of at least 5 mm. In case of openings in the barrier the requirements shown in FIGURE 13 of IEC 60065 apply, unless it is no possible for the needle flame specified in IEC 60695-2-2 to penetrate the barrier.

Printed circuit boards carrying PIS are not considered to be a barrier for the purpose of this sub clause. PIS inside electrical components are not included in this requirement.

Distances from potential ignition sources according to Table 13 of IEC 60065:

| For apparatus containing voltages not exceeding 4 kV | | | |
|---|---|---|---|
| Open circuit voltage of the POTENTIAL IGNITION SOURCE | Distance from POTENTIAL IGNITION SOURCES to components or parts | Distance from POTENTIAL IGNITION SOURCES to components or parts | Flammability category according to IEC 60707 |
| | downwards or sideways less than | Upwards less than | |
| >50 to ≤ 400 (peak) a.c. or d.c. | 13 mm | 50 mm | HB 40 |
| >400 to < 4000 (peak) a.c. or d.c. | 13 mm | 50 mm | V-1 |
| > 4000 (peak) a.c. or d.c. | - | - | - |

However, complying with the relevant flammability category of components and parts or shielding them from a PIS by a barrier made of metal to meet the flammability category FV 0 are measurements which are relatively expensive but due to design requirements hardly to be avoided in many cases. These are the facts from which the present invention starts.

In DE 74 39 095 U a printed circuit board is described which comprises an electric component with two connection wires, which are each shaped for providing a soldering at two points of each connection wire for an improved safety. Several examples for shaped connection wires are suggested for providing a connection with two soldering points for one connection wire.

Accordingly, it is object of this invention to allow more clearance regarding design and/or choice of components and parts without violation of safety requirements.

This object is solved as specified in claim 1 concerning a method for arranging an electric component while taking into consideration safety requirements, as specified in claim 2 concerning a printed circuit board on which an electric component is arranged while taking into consideration safety requirements, and as specified in claim 3 concerning an apparatus having an electric component being arranged while taking into consideration safety requirements.

The present invention is based on the idea to avoid a PIS (potential ignition source) by changing a PIS to a no-PIS. In principle, the change of a PIS to a no-PIS is accomplished by providing at least two separate soldered joints for one or each one of the connection wires of one or more relevant electric component(s) to be inserted and soldered particularly on a printed circuit board, in the following abbreviated as PCB. This(these) electric component(s) otherwise would constitute a PIS in apparatus' operation mode when, for example, its(their) respective relevant soldered joint becomes a dry joint, open circuit or the like.

According to the invention, said separate soldered joints are realized by means of a defined N-shape of the respective connection wire and correspondingly adapted to the distance of predetermined holes within a conductor trace of the PCB the respective connection wire is to be put in.

According to an embodiment of the invention, the invention has the benefit of cost saving because the clearance of 13 mm spacing, FV 0 barrier and/or FV 1 material for the chassis frame of the apparatus, have to be complied with due to the safety requirements IEC 60065, can be ignored and avoided, respectively. Extra materials are very expensive, and moreover, FV 1 is an environmentally unfriendly material.

Another benefit of the invention is that such 13 mm spacing, otherwise necessary due to safety requirements IEC 60065, are not wasted but can be used for other purposes.

The invention is explained below in more detail by way of exemplary embodiments with reference to the accompanying drawings which show in:
- Fig. 1: a rotationally symmetrical electric component on an enlarged scale having preformed connection wires;
- Fig. 2: another electric component on an enlarged scale having preformed connection wires and,
- Fig. 3: on an enlarged scale, a perspective view of an electric component having only one preformed connection wire.

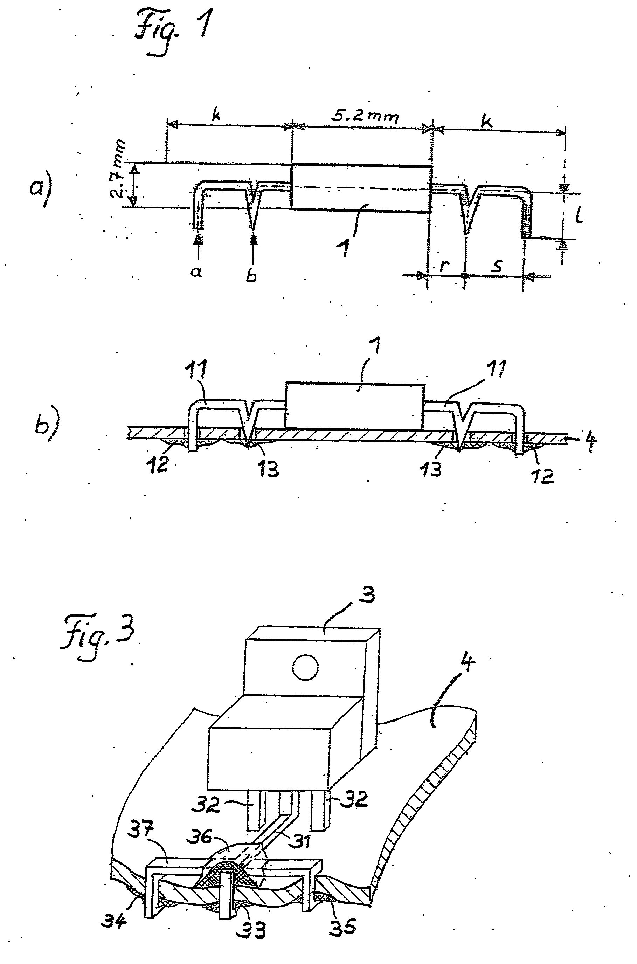

Fig. 1, Fig. 2 and Fig. 3 show electric components 1, 2, 3 being used within a switching power supply module (not shown) for power supply of an apparatus (also not shown), for example. Since the measured voltage at component's 1; 2; 3 one of their connection wires 11; 21; 31, 32 exceeds 400 Volt a.c., according to the safety requirement IEC 60065, the soldered joint of the respective relevant connection wire 11; 21; 31 (exceeding 400 Volt) is considered to be a PIS (potential ignition source) and therefore (see Table 13 of IEC 60065), must be at least 13 mm away from apparatus' plastic chassis frame if the chassis frame is made of HB 40 material, or the chassis frame must be made of FV-1 material, or, according to sub-clause 20.1.4, a FV 0 barrier can be placed in between PIS and plastic chassis (if made of HB 40 material) but 5 mm away from the PIS. Such safety measurements can be ignored due to the present invention.

Instead of such safety measurements, the electric components 1; 2; 3 are arranged particularly on a PCB (printed circuit board) 4 whereby at least two separate soldered joints are provided for one or all of the connection wires 11; 21; 31, 32. This is accomplished according to the invention by means of predeterminable soldered joints onto corresponding conductor traces (not shown) of the PCB 4 and a defined shape of the connection wires 11; 21; 31 correspondingly adaptable to the distance of the soldered joints as can be taken from solder pads 12, 13; 22, 23; 33, 34, 35, 36.

The electric components 1; 2; 3 can be of different type and therefore, as shown by Fig. 1, Fig. 2 and Fig. 3, the connection wires 11, 21, 31 are correspondingly preformed before inserting the components 1; 2; 3.

In case of a rotationally symmetrical type (Fig. 1) especially used for resistors, diodes and capacitors, the connection wires 11 are preformed to n-shape, Fig. 1 (a, b) shows the principle by means of a diode 1. The sizes of the diode 1 are k (original length of the connection wires 11) = 40 mm, 1 = 5 ± 1 mm, r = 4 ± 1 mm, s = 5 ± 1 mm. It is to be noted that the values for 1, r and s are exemplary. As particularly shown in Fig. 1(a) two contact points a, b are provided for either side of the diode 1 to be soldered as shown by the respective two solder pads 12 and 13 in Fig. 1 (b) to the same line but at two different soldered joints on the PCB 4. This example is, however, not covered by the present invention.

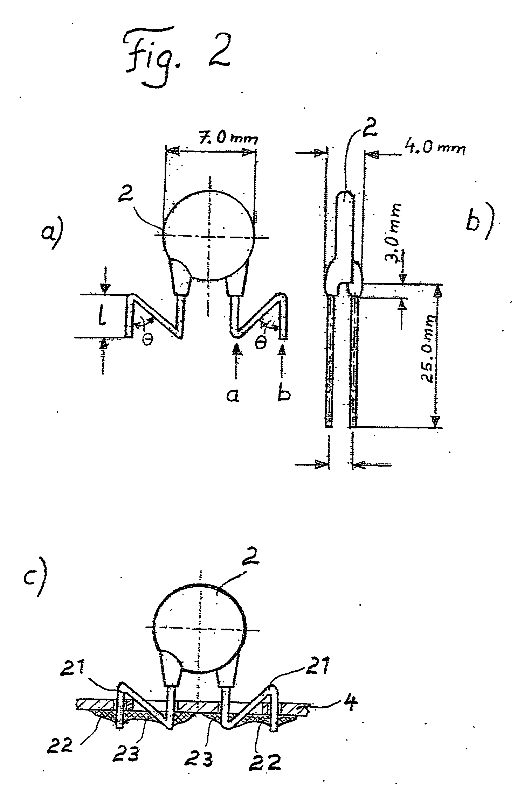

In case of a not rotationally symmetrical type (Fig. 2) as especially used for ceramic capacitors the connection wires 21 are preformed to N-shape. Fig. 2 (a, b, c) shows the principle of the invention by means of a ceramic capacitor 2. As shown in Fig. 2 (b) the original length of the connection wires 21 is 25mm, for example. Preforming the connection wires 21 to N-shape as shown in Fig. 2 (a), l is 5 ± 1 mm, for example, and the angle θ can be of 30 - 60 degrees. As particularly also shown in Fig. 1(a) two contact points a, b are provided for either side of the capacitor 2 to be soldered as shown by the respective two solder pads 22 and 23 in Fig. 2 (c) to the same line but at two different soldered joints on the PCB 4. For the respective inner soldered joint according to contact points a, the corresponding holes in the PCB 4 are oblong holes.

In case of another not rotationally symmetrical type (Fig. 3) as especially used for a power transistor type having a case according to TO 220 for example, such separate soldered joints are accomplished by a defined L-shape of the relevant connection wire 31 (exceeding 400 Volt) and an additional strap jumper 37, both correspondingly adapted to one another and the distance of their soldered joints as shown by solder pads 33, 34, 35 at conductor trace-side of the PCB 4 and by a solder pad 36 at the other side of the PCB 4. The other connection wires (not relevant regarding safety requirements) are indicated by drawing reference 32.

The strap jumper 37 is preferably added 1 mm away from the corresponding hole on the PCB 4 for the connection wire 31 but perpendicular to and under the connection wire 31. The strap jumper 37 is connected to the same copper of the connection wire 31 at the conductor trace-side of the PCB 4. The crossing point of the connection wire 31 and the strap jumper 37 is soldered. In this case, more than two contacts point are available for the connection wire 31. Hence, a PIS otherwise constituted by the relevant transistor-connection wire 31, can be avoided by means of more than two soldered joints.

## Claims

1. Method for arranging an electric component (2) of an electric circuit while taking into consideration safety requirements especially according to IEC 60065, by providing at least two separate solder pads (22, 23) for one connection wire (21) of said component (2) to be inserted and soldered particularly on a printed circuit board (4), said separate solder pads (22, 23) being realized by the following steps:
a) pre-shaping said connection wire (21) in the form of letter N,
b) putting said connection wire (21) into corresponding holes of predetermined soldered joints within a conductor trace of the printed circuit board (4), the corresponding hole for the respective inner soldered joint (23) in the PCB (4) being an oblong hole, and
c) soldering said connection wire (21) with said corresponding holes.

2. Printed circuit board (PCB) on which an electric component (2) of an electric circuit is arranged while taking into consideration safety requirements especially according to IEC 60065, by providing at least two separate solder pads (22, 23) for one connection wire (21) of said component (2), **characterized in that** said connection wire (21) is preshaped in the form of letter N, that said connection wire (21) is put into corresponding holes of predetermined soldered joints within a conductor trace of the printed circuit board (4), that the corresponding hole for the respective inner soldered joint (23) in the PCB (4) is an oblong hole, and that said connection wire (21) is soldered with said corresponding holes.

3. Apparatus, comprising a printed circuit board (4) in accordance with claim 2.

## Patentansprüche

1. Verfahren zum Anordnen eines elektrischen Bauelementes (2) einer elektrischen Schaltung, unter Berücksichtigung von Sicherheitsvorschriften, insbesondere gemäß IEC 60065, indem mindestens zwei getrennte Lötaugen (22, 23) für einen einzigen Verbindungsdraht (21) des Bauelementes (2) bereitgestellt werden, der insbesondere auf einer gedruckten Leiterplatte (4) eingeführt und verlötet werden soll, wobei die getrennten Lötaugen (22, 23) durch die nachfolgenden Schritte erstellt werden:
a) Vorformen des Verbindungsdrahtes (21) zu der Gestalt des Buchstabens N,
b) Hineinstecken des Verbindungsdrahtes (21) in entsprechende Löcher von vorbestimmten Lötverbindungen innerhalb einer Leiterbahn der gedruckten Leiterplatte (4), wobei das entsprechende Loch für die jeweilige innere Lötverbindung (23) in der gedruckten Leiterplatte (4) aus einem Langloch besteht, und
c) Verlöten des Verbindungsdrahtes (21) mit den entsprechenden Löchern.

2. Gedruckte Leiterplatte (PCB), auf welcher ein elektrisches Bauelement (2) einer elektrischen Schaltung angeordnet ist, unter Berücksichtigung von Sicherheitsvorschriften, insbesondere gemäß IEC 60065, indem mindestens zwei getrennte Lötaugen (22, 23) für einen einzigen Verbindungsdraht (21) des Bauelementes (2) bereitgestellt sind, **dadurch gekennzeichnet, dass** der Verbindungsdraht (21) zu der Gestalt des Buchstabens N vorgeformt ist, dass der Verbindungsdraht (21) in entsprechende Löcher von vorbestimmten Lötverbindungen innerhalb einer Leiterbahn der gedruckten Leiterplatte (4) hineingesteckt ist, dass das entsprechende Loch für die jeweilige innere Lötverbindung (23) in der gedruckten Leiterplatte (4) aus einem Langloch besteht, und dass der Verbindungsdraht (21) mit den entsprechenden Löchern verlötet ist.

3. Gerät, eine gedruckte Leiterplatte (4) gemäß Anspruch 2 umfassend.

## Revendications

1. Procédé permettant d'agencer un composant électrique (2) d'un circuit électrique en prenant en considération des exigences de sécurité, en particulier selon la norme EC 60065, en fournissant au moins deux coussinets de soudure séparés (22, 23) pour un fil de connexion (21) dudit composant (2) à insérer et à souder en particulier sur une carte de circuit imprimé (4), lesdits coussinets de soudure séparés (22, 23) étant réalisés par les étapes suivantes :
a) pré-formation dudit fil de connexion (21) en forme de lettre N,
b) placement dudit fil de connexion (21) dans des trous correspondants de joints brasés prédéterminés au sein d'un conducteur de la carte de circuit imprimé (4), le trou correspondant pour le joint brasé intérieur respectif (23) de la PCB (4) étant un trou oblong, et
c) soudure dudit fil de connexion (21) auxdits trous correspondants.

2. Carte de circuit imprimé (PCB) sur laquelle un composant électrique (2) d'un circuit électrique est agencé en prenant en considération des exigences de sécurité, en particulier selon la norme IEC 60065, en fournissant au moins deux coussinets de soudure séparés (22, 23) pour un fil de connexion (21) dudit composant (2), **caractérisé en ce que** ledit fil de connexion (21) est pré-formé en forme de lettre N, que ledit fil de connexion (21) est placé dans des trous correspondants de joints brasés prédéterminés au sein d'un conducteur de la carte de circuit imprimé (4), que le trou correspondant pour le joint brasé intérieur respectif (23) de la PCB (4) est un trou oblong, et que ledit fil de connexion (21) est soudé auxdits trous correspondants.

3. Appareil, comprenant une carte de circuit imprimé (4) selon la revendication 2.
